# EUROPEAN PATENT APPLICATION

(11) **EP 2 532 692 A1**
(43) Date of publication of application: **12.12.2012**
(21) Application number: 11739737.2
(22) Date of filing: 01.02.2011
(51) Int. Cl.: C08F 297/04, C08F 8/04, C08K 5/00, C08K 5/17, C08K 5/49, C08L 53/02, H01L 31/042

(54) **RESIN COMPOSITION FOR SEALING SOLAR CELL ELEMENT, AND SOLAR CELL MODULE**

(30) Priority: 02.02.2010 JP 2010021043
(71) Applicant: Zeon Corporation, Tokyo 100-8246 (JP)
(72) Inventor: TANAHASHI Naoki, Tokyo 100-8246 (JP); KOHARA Teiji, Tokyo 100-8246 (JP)
(74) Representative: Vossius & Partner
(86) International application number: PCT/JP2011/052017
(87) International publication number: WO 2011/096389

(57) **Abstract**

A resin composition comprising a hydrogenated block copolymer which is used for a resin composition for encapsulating a solar cell is provided. The hydrogenated block copolymer can be obtained by hydrogenating 90% or more of the total unsaturated bonds of block copolymers which comprise at least two polymer blocks [A] having an aromatic vinyl compound-origin repeating unit as the main component and at least one polymer block [B] comprising a chain-type conjugated diene compound-origin repeating unit as the main component and in which the ratio (wA:wB) of the weight fraction (wA) of the total polymer blocks [A], relative to the total block copolymer, to the weight fraction (wB) of the total polymer block [B] is 20:80 to 60:40. The resin composition has a tensile elasticity (at 23°C) of 1.0-500 MPa and is excellent in low hygroscopicity, non-hydrolyzablity, weather resistance, transparency, adhesiveness, flexibility, and adhesive properties with glass, and can be used for encapsulating a solar cell without providing special impermeable treatment. Also provided is a solar module in which a solar cell is encapsulated with the resin composition.

## Description

### [Technical field]

The present invention relates to a resin composition for encapsulating a solar cell and a solar module in which the solar cell is sealed with the resin composition.

### [Background Art]

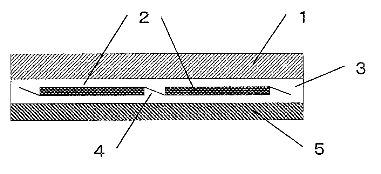

In recent years, a solar cell is attracting attentions as a clean energy. Various forms of solar modules have been proposed and developed. Particularly, a solar module using a single crystal or polycrystal type silicon solar cell, a solar module using a thin-film amorphous silicon solar cell, and the like are mainly in use. A typical solar module using a silicon solar cell is shown in Fig. 1, in which the module has a transparent front substrate 1 made of glass substrate or the like, a solar cell 2, an encapsulating material 3 which tightly seals the solar cell, and interconnecting 4 which leads to the solar cell, and a backsheet 5, arranged in this order from the sunlight incidence side. As an encapsulating material 3 which seals the solar cell, a resin obtained by curing an ethylene-vinyl acetate copolymer (EVA) using a crosslinking agent such as an organic peroxide, is widely used due to excellent transparency and light resistance.

A conventional solar cell has poor weather resistance. If used in a hot and humid outdoor environment or exposed to rain and wind over a long period of time, moisture or water penetrates inside the solar cell. As a result, interconnecting and electrodes inside the solar cell are corroded, causing deterioration of solar cell durability. Moreover, EVA used for a encapsulating material includes a unit of vinyl acetate origin which generates acetic acid when hydrolysed with time by moisture or water penetrated from outside. There is a case where the generated acetic acid comes in contact with interconnecting and electrodes inside the solar cell and accelerates corrosion.

In order to prevent corrosion of interconnecting and electrodes inside a solar cell and promote durability of the solar cell, a method of laminating an inorganic oxide deposition layer as a barrier on the backsheet (e.g. Patent Document 1), a method of using a cycloolefin resin sheet having low moisture transmission properties as a backsheet (e.g. Patent Documents 2, 3), and the like have been proposed. Although these methods could reduce transmission of moisture or water, it was difficult to completely shut out moisture and water.

In order to solve the problem of acid generation by hydrolysis of a encapsulating material, a method of adding an acid recipient to EVA or causing EVA to include a substituent reacting with an acid has been proposed (e.g., Patent Documents 4 and 5). However, although the method of excluding an acid generated from EVA was thought to reduce the effect caused by acid generation, the method could not sufficiently prevent corrosion of interconnecting and electrodes due to moisture and water permeating from outside, since EVA itself has high hygroscopic properties.

As other methods for solving the problem of acid generation by hydrolysis of a encapsulating material, a method of using a encapsulating resin composition which does not generate an acid by hydrolysis instead of EVA, such as a resin comprising an ethylene-α-olefin copolymer and a crosslinking agent (e.g., Patent Documents 6 and 7), a method of using a propylene polymer and a specific propylene copolymer (e.g., Patent Document 8), and the like have been proposed. Although the method of using an ethylene-α-olefin copolymer instead of EVA was expected to reduce the effect of acid generation, the ethylene-α-olefin copolymer cannot exhibit sufficient heat resistance due to a poor balance of heat stability and flexibility, if not cross-linked. It is also insufficient to use a propylene polymer and a specific propylene copolymer as an encapsulating material of solar cell due to its poor adhesion to glass even if the effect of acid generation and the heat resistance is improved.
Therefore, in order to markedly improve durability of a solar module by preventing corrosion, development of a encapsulating material which has a low hygroscopic property and an acid-free property by hydrolysis has been strongly desired.

### [Prior art Documents]

### [Patent Documents]

[Patent Document 1] JPA 2000-91610
[Patent Document 2] JPA 2000-106450
[Patent Document 3] JPA 2001-44481
[Patent Document 4] JPA 2005-29588
[Patent Document 5] JPA 2008-291222
[Patent Document 6] JPA 6-299125
[Patent Document 7] JPA 2000-91611
[Patent Document 8] WO2008/015984

### [Disclosure of the Invention]

### [Problems to be Solved by the Invention]

The present invention has been completed in view of these situations and has an object of providing a resin composition for encapsulating a solar cell, having low hygroscopic properties, not hydrolysable, and exhibiting excellent weather resistance, transparency, adhesive properties, and high flexibility and adhesiveness with glass without providing a special waterproof treatment, and also providing a solar module in which the solar cell is sealed with such a resin composition.

### [Means for the Solution of the Problems]

Published Japanese Translation of PCT Application 2002-531598 discloses a block copolymer obtained by hydrogenating a carbon-carbon double bond of a prepolymer which has at least three blocks, including a hard block having a structural unit originating from an aromatic vinyl monomer as a major component and a soft block having a unit originating from a conjugated diene as a major component. The PCT application describes that the block copolymer has high resistivity against heat deformation, excellent mechanical properties, high transparency, and particularly low water absorptivity, and can be used as a cover for protecting a system which is easily damaged mechanically (e.g., a field of solar cell).

The present inventors have studied application of this block copolymer for encapsulating a solar cell and have found that the block copolymer specifically described in the PCT application has poor flexibility and poor adhesiveness to glass, and impairs durability of a solar module, if used for encapsulating solar cell.
The present inventors have conducted further studies to eliminate these problems. As a result, the inventors have found that a resin composition containing a hydrogenated block copolymer which is obtained by hydrogenating a carbon-carbon unsaturated bond of a specific block copolymer is excellent in all properties, including low hygroscopicity, non-hydrolysability, weather resistance, transparency, adhesiveness, flexibility, and adhesiveness to glass, and can be used for encapsulating a solar cell without providing special impermeable treatment. This finding has led to completion of the present invention.

According to the first of the present invention, the following resin compositions (1) to (6) for encapsulating a solar cell are provided.
(1) A resin composition for encapsulating a solar cell comprising a hydrogenated block copolymer obtained by hydrogenating 90% or more of total unsaturated bonds, which is a total of carbon-carbon unsaturated bonds of main chains and side chains and carbon-carbon unsaturated bonds of aromatic rings, present in a block copolymer, which comprises at least two polymer blocks [A] having a repeating unit originating from an aromatic vinyl compound as a main component and at least one polymer block [B] comprising a repeating unit originating from a chain-like conjugated diene compound as a main component and in which the ratio of the weight fraction (wA) of the total polymer blocks [A] in the total block copolymer to the weight fraction (wB) of the total polymer block [B] in the total block copolymer (wA:wB) is 20:80 to 60:40, the resin composition having a tensile elasticity (at 23°C) of 1.0 to 500 MPa.

(2) The resin composition for encapsulating a solar cell according to (1), wherein the weight average molecular weight of the hydrogenated block copolymer is 30,000 to 200,000.
(3) The resin composition for encapsulating a solar cell according to (1) or (2), wherein the block copolymer is a triblock copolymer having the polymer block [A] bonded to the both ends of the polymer block [B].

(4) The resin composition for encapsulating a solar cell according to any one of the above (1) to (3), comprising 0.01 to 1 part by weight of a phosphorus-containing antioxidant for 100 parts by weight of the hydrogenated block copolymer.
(5) The resin composition for encapsulating a solar cell according to (4), further comprising 0.1 to 10 parts by weight of a hindered amine-containing antioxidant for 100 parts by weight of the hydrogenated block copolymer.
(6) The resin composition for encapsulating a solar cell according to (5), further comprising 0.01 to 1 part by weight of a UV absorber for 100 parts by weight of the hydrogenated block copolymer.

According to the second of the present invention, the following solar module (7) is provided.
(7) A solar module encapsulated with the resin composition for encapsulating a solar cell according to any one of (1) to (6) above.

### [Effect of the Invention]

The resin composition for encapsulating a solar cell has low hygroscopicity, non-hydrolysability, excellent weatherability, transparency, flexibility, and high adhesiveness to glass. Therefore, the resin composition of the present invention can be used for encapsulating solar cell without providing special impermeability treatment. Moreover, since the resin composition has sufficient heat resistance without curing using a crosslinking agent such as an organic peroxide, a cross-linking step can be skipped in the solar cell manufacturing process.
The solar module of the present invention has excellent durability.

### [Brief Description of Drawing]

Figure 1 is a schematic cross-sectional view showing an outline of a crystalline silicon solar module.

### [Preferred Embodiment of the Invention]

The present invention will be described in more detail in the following Chapter 1 of resin composition for encapsulating a solar cell and Chapter 2 of solar module.

### 1) Resin composition for encapsulating a solar cell

The resin composition of the present invention (hereinafter may be referred to from time to time as "resin composition of the present invention") contains a hydrogenated block copolymer in which carbon-carbon unsaturated bonds of specific block copolymers are hydrogenated.

### 1. Block copolymer

The block copolymer used in the present invention has at least two polymer blocks [A] and at least one polymer block [B].

The polymer block [A] has a repeating unit (a structural unit) originating from an aromatic vinyl compound as a major component. The content of the structural unit originating from an aromatic vinyl compound in the polymer block [A] is usually 90 wt% or more, preferably 95 wt% or more, and more preferably 99 wt% or more.

As components other than the structural unit originating from an aromatic vinyl compound in the polymer block [A], a structural unit originating from a chain-like conjugated diene compound and/or a structural unit originating from another vinyl compound can be given. The content of these components in the polymer block [A] is usually 10 wt% or less, preferably 5 wt% or less, and more preferably 1 wt% or less. If the content of the structural unit originating from an aromatic vinyl compound in the polymer block [A] is too small, heat resistance of the resin composition of the present invention may be poor.
Two or more polymer blocks [A] may be mutually the same or may be different from each other.

A polymer block [B] contains a repeating unit (structural unit) originating from a chain-like conjugated diene compound as a major component. The content of the repeating unit originating from a chain-like conjugated diene compound in the polymer block [B] is usually 50wt% or more, preferably 70 wt% or more, and more preferably 90 wt% or more. When the content of the polymer block [B] is in the above range, the resin composition of the present invention exhibits excellent and well-balanced flexibility, adhesive properties, and solar cell encapsulating capabilities.

As components other than the repeating unit originating from a chain-like conjugated diene compound in the polymer block [B], a structural unit originating from an aromatic vinyl compound and/or a structural unit originating from another vinyl compound can be given. The content of these components in the polymer block [B] is usually 30 wt% or less, and preferably 10 wt% or less. Transparency of the resin composition of the present invention increases as the content of the structural unit originating from an aromatic vinyl compound in the polymer block [B] increases. However, if the content of the structural unit originating from an aromatic vinyl compound is too much, flexibility, adhesive properties, and solar cell encapsulating capabilities of the resin composition may decrease.
When there are two or more polymer blocks [B] in the block copolymer, two or more polymeric blocks [B] may be mutually the same, or may be different from each other.

The number of the polymer blocks [A] in the block copolymer used in the present invention is usually five or less, preferably four or less, and more preferably three or less. When there are two or more polymer blocks [A] and/or two or more polymer blocks [B], the ratio of Mw(A1), which is a weight average molecular weight of the polymer block of which the weight average molecular weight is maximum in the polymer block [A], to Mw(A2), which is a weight average molecular weight the polymer block of which the weight average molecular weight is minimum in the polymer block [A], specifically [Mw(A1)/Mw(A2)], and the ratio of Mw(B1), which is a weight average molecular weight of the polymer block of which the weight average molecular weight is maximum in the polymer block [B], to Mw(B2), which is a weight average molecular weight the polymer block of which the weight average molecular weight is minimum in the polymer block [B], specifically [Mw(B1)/Mw(B2)], are respectively 2.0 or less, preferably 1.5 or less, and more preferably 1.2 or less

Although the block copolymers used in the present invention may be either a chain-like block or a radial block, a chain-like block is more preferable due to excellent mechanical strength.
Particularly preferable block copolymers are a triblock copolymer having polymer blocks [A] bonded at the both ends of a polymer block [B], and a pentablock copolymer having polymer blocks [B] bonded at the both ends of a polymer block [A] and further having polymer blocks [A] bonded at the ends of the polymer blocks [B]. The triblock copolymer having polymer blocks [A] bonded at the both ends of a polymer block [B] is particularly preferable.

In the block copolymer used in the present invention, the ratio (wA:wB) is 20:80 to 60:40, preferably 25:75 to 55:45, more preferably 30:70 to 50:50, wherein wA is the weight fraction of the total polymer blocks [A] in the total block copolymer, and wB is the weight fraction of the total polymer blocks [B] in the total block copolymer. If the value of wA is too high, the resin composition of the present invention has high heat resistance, but low flexibility, low adhesiveness and poor solar cell encapsulating capability. If wA is too low, heat resistance is poor.

The polystyrene-reduced weight average molecular weight (Mw) of the block copolymer used in the present invention measured by the gel-permeation chromatography (GPC) using tetrahydrofuran (THF) as a solvent is usually 30,000 to 200,000, preferably 40,000 to 150,000, and more preferably 50,000 to 100,000. The molecular weight distribution (Mw/Mn) of the block copolymer is preferably 3 or less, more preferably 2 or less, and particularly preferably 1.5 or less.

The block copolymer used in the present invention can be produced by a known method. For example, a block copolymer having three polymer blocks can be produced by a method having three steps; a first step of polymerizing a monomer mixture (a1) containing an aromatic vinyl compound as a monomer component for forming a polymer block [A], a second step of polymerizing a monomer mixture (bl) containing a chain-like conjugated diene compound as a monomer component for forming a polymer block [B], and a third step of polymerizing a monomer mixture (a2) containing an aromatic vinyl compound as a monomer component for forming a polymer block [A] (the monomer mixture (a1) and the monomer mixture (a2) may be the same, or may differ from each other).
A block copolymer having five polymer blocks can be produced by carrying out a fourth step of polymerizing a monomer mixture (a3) containing an aromatic vinyl compound as a monomer component for forming a polymer block [A] (the monomer mixture (a3) may be the same as or may differ from the monomer mixture (a1) and/or the monomer mixture (a2)), following the third step.

As an aromatic vinyl compound used for forming the polymer blocks [A] and [B], styrene; styrenes having a substituent on the vinyl group such as α-methylstyrene; styrenes having a substituent on the benzene ring such as 2-methylstyrene, 3-methylstyrene, 4-methylstyrene, 2,4-diisopropylstyrene, 2,4-dimethylstyrene, 4-t-butylstyrene, 5-t-butyl-2-methylstyrene, 4-mono-chlorostyrene, dichlorostyrene, 4-mono-fluorostyrene, and 4-phenylstyrene; vinylpyridines such as 4-vinylpyridine; and the like can be given. As the above-mentioned substituents, alkyl groups such as a methyl group, an ethyl group, an isopropyl group, and a t-butyl group; alkoxy groups such as a methoxy group, an ethoxy group, and a t-butoxy group; halogen atoms such as a fluorine atom, a chlorine atom, and a bromine atom; and the like can be given. Among these, in order to obtain a resin composition with low hygroscopicity, styrene, styrenes having a substituent on the vinyl group, and styrenes having an alkyl group on the benzene ring as a substituent are preferable, with styrene being particularly preferable.

As a chain-like conjugated diene compound for forming the polymer blocks [A] and [B], a compound not containing a polar group is preferable in order to obtain a resin composition with low hygroscopicity. As specific examples, 1,3-butadiene, isoprene, 2,3-dimethyl-1,3-butadiene, 1,3-pentadiene, and the like can be given. Among these, 1,3-butadiene and isoprene are particularly preferred.

As other vinyl compounds which are used for producing polymer blocks [A] and [B], chain-like vinyl compounds and cyclic vinyl compounds can be given. These compounds may have a nitrile group, an alkoxycarbonyl group, a hydroxycarbonyl group, or a halogen group as a substituent, or may be an unsaturated cyclic acid anhydride or an unsaturated imide compound. In order to produce a resin composition with low hygroscopicity, a vinyl compound which does not contain a polar group such as a chain-like olefin (e.g. ethylene, propylene, 1-butene, 1-pentene, 1-hexene, 1-heptene, 1-octene, 1-nonene, 1-decene, 1-dodecene, 1-eicosene, 4-methyl-1-pentene, and 4,6-dimethyl-1-heptene); a cycloolefin (e.g. vinylcyclohexane); and the like are preferable. Of these, a chain-like olefin is more preferable, and ethylene and propylene are particularly preferable.

As a method for polymerizing the above-mentioned monomers to produce polymer blocks, any one of radical polymerization, anionic polymerization, cationic polymerization, conjugated anionic polymerization, conjugated cationic polymerization, and the like can be used. When radical polymerization, anionic polymerization, cationic polymerization, and the like are used for a method of living polymerization, particularly living anionic polymerization, polymerization operation and hydrogenation reaction in the later process become easy and transparency of the resulting block copolymer is improved.

Polymerization is carried out in the presence of a polymerization initiator at a temperature in a range of 0 to 100°C, preferably 10 to 80°C, and particularly preferably 20 to 70°C.
A known polymerization initiator (radical initiator, anionic initiator, cationic initiator, etc.) can be used without a particular limitation.
For example, in the case of living anionic polymerization, a mono-organolithium such as n-butyl lithium, sec-butyl lithium, t-butyl lithium, hexyl lithium, and phenyl lithium; a polyfunctional organolithium compound such as dilithiomethane, 1,4-dilithiobutane, and 1,4-dilithio-2-ethyl cyclohexane; and the like can be used.

Any polymerization method such as solution polymerization, slurry polymerization, and the like can be used. If solution polymerization is used, heat of reaction can be easily removed. In this case, an inert solvent which dissolves the resulting polymer in each step is used as a solvent. As examples of an inert solvent which can be used, aliphatic hydrocarbons such as n-butane, n-pentane, isopentane, n-hexane, n-heptane, and isooctane; alicyclic hydrocarbons such as cyclopentane, cyclohexane, methylcyclopentane, methylcyclohexane, decalin, bicyclo[4.3.0]-nonane, and tricyclo[4.3.0.1^{2,5}]decane; aromatic hydrocarbons such as benzene and toluene; and the like can be given. Of these, alicyclic hydrocarbons are preferable because alicyclic hydrocarbons can be used as an inert solvent in the later-described hydrogenation reaction and exhibit excellent solubility of block copolymers.
These solvents may be used either independently or two or more solvents may be used in combination.
The amount of the solvent used is 200 to 2,000 parts by weight per 100 parts by weight of the total amount of monomers used.

When a monomer mixture contains two or more different monomers, a randomizer or the like can be used in order to prevent extension of only a polymer chain of a specific component. In particular, when anionic polymerization is used in the polymerization reaction, use of a Lewis base compound as a randomizer is preferable.

Examples of a Lewis base compound which can be used include ether compounds such as dimethyl ether, diethyl ether, diisopropyl ether, dibutyl ether, tetrahydrofuran, diphenyl ether, ethylene glycol diethyl ether, and ethylene glycol methylphenyl ether; tertiary amine compounds such as tetramethylethylenediamine, trimethylamine, triethylamine, and pyridine; alkali metal alkoxide compounds such as potassium t-amyl oxide and potassium t-butyl oxide; phosphine compounds such as triphenylphosphine; and the like. These Lewis base compounds may be used either independently or in combination of two or more.

### 2. Hydrogenated block copolymer

The hydrogenated block copolymer used in the present invention has hydrogenated carbon-carbon unsaturated bonds in main chains and side chains, and hydrogenated carbon-carbon unsaturated bonds in aromatic rings. The hydrogenation rate is 90% or more, preferably 97% or more, and more preferably 99% or more. The higher the hydrogenation rate, the better the transparency, weather resistance, and heat resistance of the resin composition of the present invention. The hydrogenation rate of the hydrogenated block copolymers used in the present invention is determined by ¹H-NMR analysis.

The method of hydrogenation of unsaturated bonds is not particularly limited in the present invention. A known method which can attain a high hydrogenation rate while suppressing a polymer chain cutting reaction is preferably used. For example, a method of hydrogenation using hydrogen gas in the presence of a hydrogenation catalyst containing at least one metal selected from the group consisting of nickel, cobalt, iron, titanium, rhodium, palladium, platinum, ruthenium, rhenium, and the like can be given. Either a heterogeneous catalyst or a homogeneous catalyst may be used as the hydrogenation catalyst. The hydrogenation reaction is preferably carried out in an organic solvent.

A catalyst comprising a metal or a metallic compound, or a supported catalyst in which a catalyst is supported on a suitable carrier can be used as a heterogeneous catalyst. As a carrier, activated carbon, silica, alumina, calcium carbonate, titanium dioxide, magnesia, zirconia, diatomaceous earth, silicon carbide, calcium fluoride, and the like can be given. The amount of the catalyst supported on a carrier is usually 0.1 to 60 wt%, and preferably 1 to 50 wt%.
A supported catalyst having a specific surface area of 100 to 500 m²/g and an average pore diameter of 100 to 1000 angstrom, particularly 200 to 500 angstrom, is preferable. The value of the specific surface area is determined by measuring the amount of nitrogen adsorption and calculating using the BET formula. The value of the average pore diameter is measured by the mercury porosimetry method.

As a homogeneous catalyst, a catalyst comprising a nickel, cobalt, titanium, or iron compound in combination with an organometallic compound (e.g. an organoaluminum compound, an organolithium compound, etc.); an organic metal complex catalyst of a metal such as rhodium, palladium, platinum, ruthenium, or rhenium; and the like can be used.

As a nickel, cobalt, titanium, or iron compound, an acetylacetonate compound, a carboxylate, a cyclopentadienyl compound, or the like of nickel, cobalt, titanium, or iron can be given.

As an organoaluminum compound, an alkyl aluminum such as triethylaluminum and triisobutylaluminum; an aluminum halide such as diethyl aluminum chloride and ethyl aluminum dichloride; a hydrogenated alkyl aluminum such as diisobutylaluminum hydride; and the like can be given.

As an organic metal complex catalyst, a transition metal complex such as dihydride-tetrakis (triphenylphosphine) ruthenium, dihydride-tetrakis(triphenylphosphine) iron, bis(cyclooctadiene) nickel, bis(cyclopentadienyl) nickel, and the like can be given.

These hydrogenation catalysts may be used either independently or may be used in combination with two or more of them.
The amount of the hydrogenation catalyst used is usually 0.01 to 100 parts by weight, preferably 0.05 to 50 parts by weight, and more preferably 0.1 to 30 parts by weight for 100 parts by weight of the polymer.

The hydrogenation reaction temperature is usually 10 to 250°C, preferably 50 to 200°C, and more preferably 80 to 180°C. A high hydrogenation rate with least molecular cut can be ensured in these temperature ranges.
The hydrogen pressure in the hydrogenation reaction is usually 0.1 to 30 MPa, preferably 1 to 20 MPa, and more preferably 2 to 10 MPa. A high hydrogenation rate, a minimal molecular cut amount, and excellent operating conditions can be ensured in these hydrogen pressure ranges.

After the hydrogenation reaction, the hydrogenation catalyst and/or the polymerization catalyst are removed from the reaction solution by a method such as filtration or centrifugation, for example. The hydrogenated block copolymer is recovered from the resultant solution. As a method for collecting the target hydrogenated block copolymer from the reaction solution, publicly known methods such as a steam solidifying method of removing the solvent in which the hydrogenated block copolymer is dissolved by steam stripping, a direct solvent-removal method of removing the solvent by heating under reduced pressure, a solidification method of causing the hydrogenated block copolymer to deposit and solidify by pouring the reaction solution into a poor solvent, and the like can be given.

Although there are no particular limitations to the form of the collected hydrogenated block copolymer, the copolymer product is usually made into the form of pellets which are easily handled in subsequent processing.
A publicly known method such as a direct deliquoring method and a solidification method can be given, as a method for forming pellets. When using the direct deliquoring method, the hydrogenated block copolymer in a molten state is extruded from a die in a stranded form, cooled down, and cut into a pellet form using a pelletizer. Pellets thus obtained are used for forming various articles. When using the solidification method, a solidified product is dried and extruded from an extruder in a molten state, and formed into pellets. The resulting pellets are used as a solar cell encapsulating material, for example.
Additives such as an antioxidant (described later) may be incorporated when the hydrogenated block copolymer is formed in the shape of pellets.

The polystyrene-reduced weight average molecular weight (Mw) of the hydrogenated block copolymer used in the present invention measured by GPC using THF as a solvent is usually 30,000 to 200,000, preferably 40,000 to 150,000, and more preferably 50,000 to 100,000. When Mw of the hydrogenated block copolymer is in these ranges, the resulting resin composition has high mechanical strength and high heat resistance.
The molecular weight distribution (Mw/Mn) of the hydrogenated block copolymer is controlled in a range of preferably 3 or less, more preferably 2 or less, and particularly preferably 1.5 or less. The resin composition exhibits improved mechanical strength and heat resistance, when Mw/Mn is in these ranges.

### 3. Resin composition for encapsulating solar cell

The resin composition of the present invention comprises the above-mentioned hydrogenated block copolymer and has a tensile modulus of elasticity of 1.0 to 500 MPa, and preferably 2 to 300 MPa. If the tensile modulus of elasticity is too low, the solar module can hold the solar cell only with difficulty and tends to be deformed. If the tensile modulus of elasticity is too high, the solar cell easily produces a failure such as cracks. It is possible to increase the tensile modulus of elasticity by increasing wA of the block copolymer and to decrease the tensile modulus of elasticity by decreasing wA.

The content of the hydrogenated block copolymer in the resin composition of the present invention is usually 60 wt% or more, preferably 75 wt% or more, and more preferably 90 wt% or more, of the total amount of the resin composition.

In addition to the hydrogenated block copolymer, any desired additives may be incorporated in the resin composition for encapsulating a solar cell in order to increase its performance.
As such additives, a polymer other than the hydrogenated block copolymer to increase the resin characteristics; an antioxidant, a photostabilizer, and an UV absorber to improve weatherability, heat resistance, and the like; a coupling agent, a lubricant, a surfactant, and an inorganic filler to improve adhesive properties and encapsulating properties; and the like can be given. These additives may be used either independently of in combination of two or more.
Of these, use of an antioxidant, a photostabilizer, and an UV absorber is preferable and combined use of an antioxidant, a photostabilizer, and/or an UV absorber is particularly preferable.

### [Polymers other than hydrogenated block copolymer]

As polymers other than the above-mentioned hydrogenated block copolymers, olefin-based polymers such as an ethylene-propylene copolymer and a propylene-ethylene-1-butene copolymer; isobutylene-based polymers such as polyisobutylene and a hydrogenated isobutylene-isoprene copolymer; hydrogenated diene-based polymers such as polyisoprene, an isoprene-butadiene random copolymer, a butadiene-styrene random copolymer, an isoprene-styrene random copolymer, an acrylonitrile-butadiene random copolymer, an acrylonitrile-styrene-butadiene rubber copolymer, a butadiene-styrene block copolymer, and an isoprene-styrene block copolymer; acrylic polymers such as poly(butyl acrylate) and poly(hydroxyethyl methacrylate); epoxy-based polymers such as polyethylene oxide, polypropylene oxide, and an epichlorhydrin rubber; petroleum resins and hydrogenated petroleum resins such as a 1,3-pentadiene petroleum resin, a cyclopentadiene petroleum resin, and an aromatic petroleum resin; and the like can be given. Of these resins, petroleum resins are preferable in order to promote transparency and adhesiveness of the resin composition for encapsulating a solar cell.

### [Antioxidant]

An antioxidant may be added to the resin composition of the present invention in order to increase heat stability.
As an antioxidant which can be used, a phosphorus-containing antioxidant, a phenolic antioxidant, a sulfur-containing antioxidant, and the like can be mentioned. Of these, a phosphorus-containing antioxidant by which the resin is colored only a small extent is preferable.

As a phosphorus-containing antioxidant, monophosphite compounds such as triphenyl phosphite, diphenyl isodecyl phosphite, phenyl diisodecyl phosphite, tris(nonylphenyl)phosphite, tris(dinonylphenyl)phosphite, tris(2,4-di-t-butylphenyl)phosphate, and 10-(3,5-di-t-butyl-4-hydroxybenzyl)-9,10-dihydro-9-oxa-10-phosphaphenanthrene-10-oxide; diphosphite compounds such as 4,4'-butylidene bis(3-methyl-6-t-butylphenyl-di-tridecylphosphite), 4,4'-isopropylidene bis(phenyl-di-alkyl(C₁₂-C₁₅) phosphite), and the like; 6-[3-(3-t-butyl-4-hydroxy-5-methylphenyl)propoxy]-2,4,8,10-tetrakis-t-butyl-di-benzo[d,f][1.3.2]dioxaphosphepin, 6-[3-(3,5-di-t-butyl-4-hydroxyphenyl)propoxy]-2,4,8,10-tetrakis-t-butyl-di-benzo[d,f][1.3.2]dioxaphosphepin, and the like can be given.

As a phenolic antioxidant, pentaerythrityl-tetrakis[3-(3,5-di-t-butyl-4-hydroxyphenyl)propionate], 2,2-thio-diethylenebis[3-(3,5-di-t-butyl-4-hydroxyphenyl)propionate], octadecyl-3-(3,5-di-t-butyl-4-hydroxyphenyl)propionate,3,9-bis{2-[3-(3-t-butyl-4-hydroxy-5-methylphenyl)propionyloxy]-1,1-dimethylethyl}-2,2,4,8,10-tetraoxaspiro[5,5]undecane, 1,3,5- trimethyl-2,4,6-tris(3,5-di-t-butyl-4-hydroxybenzyl)benzene, and the like can be given.

As a sulfur-containing antioxidant, dilauryl-3,3'-thiodipropionate, dimylistyl-3,3'-thiodipropionate, distearyl-3,3'-thiodipropionate, laurylstearyl-3,3'-thiodipropionate, pentaerythritol-tetrakis(β-lauryl-thio-propionate), 3,9-bis(2-dodecylthioethyl)-2,4,8,10-tetraoxaspiro[5,5]undecane, and the like can be given.

The amount of an antioxidant is usually 0.01 to 1 wt%, preferably 0.05 to 0.5 wt%, and more preferably 0.1 to 0.3 wt% for 100 wt% of the hydrogenated block copolymer.

### [Photostabilizer]

As a photostabilizer, a hindered-amine photostabilizer is a preferable. A compound having a 3,5-di-t-butyl-4-hydroxyphenyl group, a 2,2,6,6-tetramethylpiperidyl group, a 1,2,2,6,6-pentamethyl-4-piperidyl group, or the like in the structure can be given.

Specific examples include a mixed ester compound of 1,2,3,4-butanetetracarboxylic acid, 1,2,2,6,6-pentamethyl-4-piperidinol, and 3,9-bis(2-hydroxy-1,1-dimethylethyl)-2,4,8,10-tetraoxaspiro[5,5]undecane; a polycondensate of 1,6-hexanediamine-N,N'-bis(2,2,6,6-tetramethyl-4-piperidyl) and morpholino-2,4,6-trichloro-1,3,5-triazine; 1-[2-[3-(3,5-di-t-butyl-4-hydroxyphenyl)propionyloxy]ethyl]-4-[3-3,5-di-t-butyl-4-hydroxyphenylpropionyloxy]-2,2,6,6-tetramethylpiperidine, bis-(1,2,2,6,6-pentamethyl-4-piperidyl) 2-(3,5-di-t-butyl-4-hydroxybenzyl)-2-n-butylmalonate, bis-(1,2,2,6,6-pentamethyl-4-piperidyl) 2-(3,5-di-t-butyl-4-hydroxybenzyl)-2-n-butylmalonate, 4-(3-(3,5-di-t-butyl-4-hydroxyphenyl)propionyloxy)-1-(2-(3-(3,5-di-t-butyl-4-hydroxyphenyl)propionyloxy)ethyl)-2,2,6,6-tetramethylpiperidine, 4-(N-(1-benzyl-2-phenylethyl)-N-formylamino)-2,2,6,6-tetramethylpiperidine, 4-(N-(2-(1-pyrrolidyl)ethyl)-N-formylamino)-2,2,6,6-tetramethylpiperidine, 4-(N-(2-(4-morpholinyl)ethyl)-N-formylamino)-2,2,6,6-tetramethyl-N-methylpiperidine, 4-(N-(2- (4-morpholinyl)ethyl)-N-formylamino)-2,2,6,6-tetramethylpiperidine, 4-(N-(2-(diisopropylamino)ethyl)-N-formylamino)-2,2,6,6-tetramethylpiperidine, 4-(N-(2,4,6-trimethylbenzyl)-N-formylamino)-2,2,6,6-tetramethylpiperidine, 4-(N-(3-(2-ethylhexoxy)propyl)-N-formylamino)-2,2,6,6-tetramethylpiperidine, 4-(N-(3,4-(methylenedioxy)benzyl)-N-formylamino)-2,2,6,6-tetramethylpiperidine, 4-(N-(bicyclo[2.2.1]heptyl)-N-formylamino)-2,2,6,6-tetramethylpiperidine, 4-(N-1,2,2-trimethylpropyl-N-formylamino)-2,2,6,6-tetramethylpiperidine, 4-(N-1,3-dimethylbutyl-N-formylamino)-2,2,6,6-tetramethylpfperidine, 4-(N-1-benzylethyl-N-formylamino)-2,2,6,6-tetramethylpiperidine, 4-(N-2,2-dimethylpropyl-N-formylamino)-2,2,6,6-tetramethylpiperidine, 4-(N-2-ethylhexyl-N-formylamino)-2,2,6,6-tetramethylpiperidine, 4-(N-3-methylbutyl-N-formylamino)-2,2,6,6-tetramethylpiperidine, 4-(N-4-hydroxybutyl-N-formylamino)-2,2,6,6-tetramethylpiperidine, 4-(N-4-hydroxybutyl-N-formylamino)-2,2,6,6-tetramethylpiperidine, 4-(N-i-propyl-N-formylamino)-2,2,6,6-tetramethylpiperidine, 4-(N-i-propyl-N-formylamino)-2,2,6,6-tetramethylpiperidine, 4-(N-t-butyl-N-formylamino)-2,2,6,6-tetramethylpiperidine, 4-(N-isopropylbenzyl-N-formylamino)-2,2,6,6-tetramethylpiperidine, 4-(N-ethoxyethyl-N-formylamino)-2,2,6,6-tetramethylpiperidine, 4-(N-ethoxypropyl-N-formylamino)-2,2,6,6-tetramethylpiperidine, 4-(N-octadecyl-N-formylamino)-2,2,6,6-tetramethylpiperidine, 4-(N-octyl-N-formylamino)-2,2,6,6-tetramethyl-N-methylpiperidine, 4-(N-octyl-N-formylamino)-2,2,6,6-tetramethylpiperidine, 4-(N-chlorobenzyl-N-formylamino)-2,2,6,6-tetramethylpiperidine, 4-(N-diethylaminoethyl-N-formylamino)-2,2,6,6-tetramethylpiperidine, 4-(N-cyclododecyl-N-formylamino)-2,2,6,6-tetramethylpiperidine, 4-(N-cyclohexyl-N-formylamino)-2,2,6,6-tetramethyl-N-methylcarbonylpiperidine, 4-(N-cyclohexyl-N-formylamino)-2,2,6,6-tetramethyl-N-methylpyridine, 4-(N-cyclohexyl-N-formylamino)-2,2,6,6-tetramethylpyridine, 4-(N-cyclopentyl-N-formylamino)-2,2,6,6-tetramethyl-N-methylpiperidine, 4-(N-cyclopentyl-N-formylamino)-2,2,6,6-tetramethylpiperidine, 4-(N-dimethylaminopropyl-N-formylamino)-2,2,6,6-tetramethylpiperidine, 4-(N-decyl-N-formylamino)-2,2,6,6-tetramethyl-N-methylpiperidine, 4-(N-decyl-N-formylamino)-2,2,6,6-tetramethylpiperidine, 4-(N-dodecyl-N-formylamino)-2,2,6,6-tetramethylpiperidine, 4-(N-pyridinylmethyl-N-formylamino)-2,2,6,6-tetramethylpiperidine, 4-(N-phenylethyl-N-formylamino)-2,2,6,6-tetramethyl-N-methyl pyridine, 4-(N-phenylethyl-N-formylamino)-2,2,6,6-tetramethylpyridine, 4-(N-butyl-N-formylamino)-2,2,6,6-tetramethyl-N-methylpiperidine, 4-(N-butyl-N-formylamino)-2,2,6,6-tetramethyl-N-methylpiperidine, 4-(N-fluorobenzyl-N-formylamino)-2,2,6,6-tetramethylpiperidine, 4-(N-hexyl-N-formylamino)-2,2,6,6-tetramethyl-N-methylpiperidine, 4-(N-hexyl-N-formylamino)-2,2,6,6-tetramethylpiperidine, 4-(N-pentyl-N-formylamino)-2,2,6,6-tetramethyl-N-methylpiperidine, 4-(N-pentyl-N-formylamino)-2,2,6,6-tetramethylpiperidine, 4-(N-methylcyclohexyl-N-formylamino)-2,2,6,6-tetramethylpyridine, 4-(N-methylbenzyl-N-formylamino)-2,2,6,6-tetramethylpiperidine, 4-(N-methoxybenzyl-N-formylamino)-2,2,6,6-tetramethylpiperidine, 4-(formylamino)-2,2,6,6-tetramethyl-N-methylpiperidine, 4-(formylamino)-2,2,6,6-tetramethylpiperidine, 4-[N-(2,2,6,6-tetramethyl-4-piperidyl)-N-formylamino]-2,2,6,6-tetramethyl-N-methylpyridine, 4-[N-(2,2,6,6-tetramethyl-4-piperidyl)-N-formylamino]-2,2,6,6-tetramethylpyridine, N,N',N",N"'-tetrakis(4,6-bis(butyl(N-methyl-2,2,6,6-tetramethylpiperidin-4-yl)amino)-triazin-2-yl-4,7-diazadecane-1,10-amine, N,N'-bis(2,2,6,6-tetramethyl-4-N-methylpiperidyl)-N,N'-diformyl-1,4-xylylenediamine, N,N'-bis(2,2,6,6-tetramethyl-4-N-methylpiperidyl)-N,N'-diformyl-trimethylenediamine, N,N'-bis(2,2,6,6-tetramethyl-4-N-methylpiperidyl)-N,N'-diformyl-hexamethylenediamine, N,N'-bis(2,2,6,6-tetramethyl-4-N-methylpiperidyl)-N,N'-diformyl-ethylenediamine, N,N'-bis(2,2,6,6-tetramethyl-4-piperidyl)-N,N'-diformyl-1,4-xylylenediamine, N,N'-bis(2,2,6,6-tetramethyl-4-piperidyl)-N,N'-diformylethylenediamine, N,N'-bis(2,2,6,6-tetramethyl-4-piperidyl)-N,N'-diformyltrimethylenediamine, N,N'-bis(2,2,6,6-tetramethyl-4-piperidyl)-N,N'-diformylhexamethylenediamine, N,N'-bis(2,2,6,6-tetramethyl-4-piperidyl)-N,N'-bishexamethyleneacrylic acid amide, N,N'-bis(2,2,6,6-tetramethyl-4-piperidyl)-N,N'-bishexamethylenearachic acid amide, N,N'-bis(2,2,6,6-tetramethyl-4-piperidyl)-N,N'-bishexamethyleneangelic acid amide, N,N'-bis(2,2,6,6-tetramethyl-4-piperidyl)-N,N'-bishexamethyleneundecylic acid amide, N,N'-bis(2,2,6,6-tetramethyl-4-piperidyl)-N,N'-bishexamethyleneundecylenic acid amide, N,N'-bis(2,2,6,6-tetramethyl-4-piperidyl)-N,N'-bishexamethyleneoleic acid amide, N,N'-bis(2,2,6,6-tetramethyl-4-piperidyl)-N,N'-bishexamethylenegadoleic acid amide, N,N'-bis(2,2,6,6-tetramethyl-4-piperidyl)-N,N'-bishexamethylenecaprylic acid amide, N,N'-bis(2,2,6,6-tetramethyl-4-piperidyl)-N,N'-bishexamethylenecapric acid amide, N,N'-bis(2,2,6,6-tetramethyl-4-piperidyl)-N,N'-bishexamethylenecaproic acid amide, N,N'-bis(2,2,6,6-tetramethyl-4-piperidyl)-N,N'-bishexamethylenecrotonic acid amide, N,N'-bis(2,2,6,6-tetramethyl-4-piperidyl)-N,N'-bishexamethylenecitronellic acid amide, N,N'-bis(2,2,6,6-tetramethyl-4-piperidyl)-N,N'-bishexamethylenestearic acid amide, N,N'-bis(2,2,6,6-tetramethyl-4-piperidyl)-N,N'-bishexamethylenezoomaric acid amide, N,N'-bis(2,2,6,6-tetramethyl-4-piperidyl)-N,N'-bishexamethylenetridecylic acid amide, N,N'-bis(2,2,6,6-tetramethyl-4-piperidyl)-N,N'-bishexamethylenenonadecylic acid amide, N,N'-bis(2,2,6,6-tetramethyl-4-piperidyl)-N,N'-bishexamethylenepalmitic acid amide, N,N'-bis(2,2,6,6-tetramethyl-4-piperidyl)-N,N'-bishexamethylenebrenzterebic acid amide, N,N'-bis(2,2,6,6-tetramethyl-4-piperidyl)-N,N'-bishexamethylenepropionic acid amide, N,N'-bis(2,2,6,6-tetramethyl-4-piperidyl)-N,N'-bishexamethyleneheptanoic acid amide, N,N'-bis(2,2,6,6-tetramethyl-4-piperidyl)-N,N'-bishexamethylenebehenic acid amide, N,N'-bis(2,2,6,6-tetramethyl-4-piperidyl)-N,N'-bishexamethylenepelargonic acid amide, N,N'-bis(2,2,6,6-tetramethyl-4-piperidyl)-N,N'-bishexamethylenepentadecylic acid amide, N,N'-bis(2,2,6,6-tetramethyl-4-piperidyl)-N,N'-bishexamethylenemargaric acid amide, N,N'-bis(2,2,6,6-tetramethyl-4-piperidyl)-N,N'-bishexamethylenemyristic acid amide, N,N'-bis(2,2,6,6-tetramethyl-4-piperidyl)-N,N'-bishexamethylenelauric acid amide, N,N'-bis(2,2,6,6-tetramethyl-4-piperidyl)-N,N'-bishexamethylenelinderic acid amide, N,N'-bis(2,2,6,6-tetramethyl-4-piperidyl)-N,N'-bishexamethylenevaleric acid amide, N,N'-bis(2,2,6,6-tetramethyl-4-piperidyl)-N,N'-bishexamethyleneacetic acid amide, N,N'-bis(2,2,6,6-tetramethyl-4-piperidyl)-N,N'-bishexamethylenecitric acid amide, N,N'-bis(2,2,6,6-tetramethyl-4-piperidyl)-N,N'-bishexamethylenebutyric acid amide, a polymer of dimethyl succinate and 4-hydroxy-2,2,6,6-tetramethyl-1-piperidineethanol, a polycondensate of dibutyl amine, 1,3,5- triazine, and N,N'-bis(2,2,6,6-tetramethyl-4-piperidyl)butylamine, bis(1,2,2,6,6-pentamethyl-4-piperidyl)-2-(3,5-dit-butyl-4-hydroxybenzyl)-2-n-butylmalonate, bis(2,2,6,6-tetramethyl-4-piperidyl)sebacate, poly[(6-morpholino-s-triazin-2,4-diyl)[(2,2,6,6-tetramethyl-4-piperidyl)imino]-hexamethylene[(2,2,6,6-tetramethyl-4-piperidyl)imino], poly[{(1,1,3,3-tetramethybutyl)amino-1,3,5- triazin-2,4-diyl}{(2,2,6,6-tetramethyl-4-piperidyl)imino}hexamethylene{(2,2,6,6-tetramethyl-4-piperidyl)imino}], poly[{6-(1,1,3,3-tetramethylbutyl)amino-1,3,5-triazin-2,4-diyl} {(2,2,6,6-tetramethyl-4-piperidyl)imino}hexamethylene{(2,2,6,6-tetramethyl-4-piperidyl)imino}], a reaction product of a polymer of N,N'-bis(2,2,6,6-tetramethyl-4-piperidinyl)-1,6-hexanediamine and 2,4,6-trichloro-1,3,5-triazine, N-butyl-1-butanamine, and N-butyl-2,2,6,6-tetramethyl-4-piperidineamine, and the like.

Among the above compounds, N,N'-bis(2,2,6,6-tetramethyl-4-N-methylpiperidyl)-N,N'-diformylalkylenediamines, N,N'-bis(2,2,6,6-tetramethyl-4-piperidyl)-N,N'-diformylalkylenediamines, N,N'-bis(2,2,6,6-tetramethyl-4-piperidyl)-N,N'-bisalkylene fatty-acid amides, poly[{6-(1,1,3,3-tetramethylbutyl)amino-1,3,5- triazin-2,4-diyl} {(2,2,6,6-tetramethyl-4-piperidyl)imino}hexamethylene{(2,2,6,6-tetramethyl-4-piperidyl)imino}] are preferable from the viewpoint of excellent weatherarability, with N,N'-bis(2,2,6,6-tetramethyl-4-piperidyl)-N,N'-diformylalkylenediamines and a reaction product of a polymer of N,N'-bis(2,2,6,6-tetramethyl-4-piperidinyl)-1,6-hexanediamine and 2,4,6-trichloro-1,3,5- triazine, N-butyl-1-butanamine, and N-butyl-2,2,6,6-tetramethyl-4-piperidineamine being particularly preferable.

The amount of a hindered-amine photostabilizer incorporated is usually 0.1 to 10 parts by weight, preferably 0.5 to 7 parts by weight, and more preferably 1 to 5 parts by weight for 100 parts by weight the hydrogenated block copolymer. When the amount of the hindered-amine photostabilizer is smaller than the amount of these ranges, the effect of the weather resistance of the resin composition for encapsulating a solar cell is necessarily sufficient. When the amount is larger than these ranges, T die of an extruder or a cooling roller is remarkably soiled at the time of melt-fabrication operation for producing a sheet of the resin composition for encapsulating a solar cell. Workability is unduly poor and the operation is not industrial.
The hindered-amine photostabilizer can further improve light resistance, if used together with am antioxidant, particularly with a phosphorus antioxidant.

### [UV absorber]

An UV absorber can also be added to the resin composition of the present invention in order to increase light resistance. As examples of UV absorbers, benzophenone UV absorbers, salicylic acid UV absorbers, benzotriazole UV absorbers, and the like can be given.

As benzophenone UV absorbers, 2,4-dihydroxybenzophenone, 2-hydroxy-4-methoxybenzophenone, 2-hydroxy-4-methoxybenzophenone-5-sulfonic acid trihydrate, 2-hydroxy-4-octyloxybenzophenone, 4-dodecaloxy-2-hydroxybenzophenone, 4-benzyloxy-2-hydroxybenzophenone, 2,2',4,4'-tetra-hydroxybenzophenone, 2,2'-dihydroxy-4,4'-dimethoxybenzophenone and the like can be given. As salicylic acid UV absorbers, phenylsalicylate, 4-t-butylphenyl-2-hydroxybenzoate, phenyl-2-hydroxybenzoate, 2,4-di-t-butylphenyl-3,5-di-t-butyl-4-hydroxybenzoate, hexadecyl-3,5-di-t-butyl-4-hydroxybenzoate, and the like can be given. As benzotriazole UV absorbers, 2-(2-hydroxy-5-methylphenyl)2H-benzotriazole, 2-(3-t-butyl-2-hydroxy-5-methylphenyl)-5-chloro-2H-benzotriazole, 2-(3,5-di-t-butyl-2-hydroxyphenyl)-5-chloro-2H-benzotriazole, 2-(3,5-di-t-butyl-2-hydroxyphenyl)-2H-benzotriazole, 5-chloro-2-(3,5-di-t-butyl-2-hydroxyphenyl)-2H-benzotriazole, 2-(3,5-di-t-amyl-2-hydroxyphenyl)-2H-benzotriazole, 2-(2-hydroxy-5-t-octylphenyl)-2H-benzotriazole, 2-(2-hydroxy-4-octylphenyl)-2H-benzotriazole, 2-(2H-benzotriazole-2-yl)-4-methyl-6-(3,4,5,6-tetrahydrophthalidylmethyl)phenol, 2,2'-methylenebis[4-(1,1,3,3-tetramethylbutyl)-6-[(2H-benzotriazol-2-yl)phenol]], and the like can be given.

The amount of UV absorbers is usually 0.01 to 1 part by weight, preferably 0.05 to 0.5 parts by weight, and more preferably 0.1 to 0.3 parts by weight for 100 parts by weight of the hydrogenated block copolymer. Although UV absorbers can further improve light resistance by using together with a hindered amine photostabilizer, addition of an UV absorber in excess of the above-mentioned amount cannot bring about an effect proportionate to the excess amount.

When the resin composition of the present invention contains additives in addition to the hydrogenated block copolymer, the resin composition of the present invention is prepared by homogeneously dispersing the additives in the hydrogenated block copolymer.
As a method for homogeneously dispersing the additives in the hydrogenated block copolymer, for example, a method of dissolving the additives in a suitable solvent, adding the solution to a solution of the hydrogenated block copolymer, and removing the solvent to collect the hydrogenated block copolymer containing the additives; a method of bringing the hydrogenated block copolymer into a molten state using a biaxial kneader, a roll, a Brabender , an extruder, or the like, and kneading the additives; and the like can be given.

Since the resin composition of the present invention excels in low hygroscopicity, non-hydrolysability, weather resistance, transparency, flexibility, and adhesiveness to glass, the resin composition is suitable as a encapsulating material of an electric or electronic device, particularly as a solar cell encapsulating material.

### 2) Solar module

The solar module of the present invention comprises a solar cell encapsulated with the resin composition of the present invention.

The resin composition of the present invention is usually formed in a shape of a sheet for use as a solar cell encapsulating material in a process of fabricating a solar module.

Although not particularly limited, the thickness of a sheet is preferably in a range of 0.1 to 1 mm. When a crystalline silicon wafer is used as a solar cell which usually has a thickness of 0.2 to 0.3 mm, the thickness of a sheet of the resin composition for encapsulating a solar cell is preferably 0.3 to 0.5 mm. If the thickness of the sheet is less than 0.1 mm, glass and a solar cell may be easily damages in the heating lamination step in the fabrication of a solar module. A sheet having a thickness larger than 1 mm has problems such as poor light transmission and requirement of a large amount of the resin composition for encapsulating a solar cell, resulting in a production cost increase.

There are no particular limitations to the method of sheet fabrication. A known melt extrusion molding (cast molding, extrusion sheet forming, inflation molding, etc.), compression molding, calendering, and the like can be used.

The sheet forming conditions are suitably selected according to the forming method. For example, in the case of melt extrusion molding, the resin temperature is selected from a range of usually 180 to 280°C, preferably 200 to 260°C, and more preferably 220 to 250°C. If the resin temperature is too low, fluidity is poor and the formed sheet tends to have a defect such as small dots like orange skin or a die line. On the other hand, if the resin temperature is too high, the hydrogenated block copolymer may be thermally decomposed and produce a silver streak. Moreover, the molecular weight may decrease, resulting in a defect such as a decrease in mechanical strength, and the like.
Since the resin composition of the present invention does not require addition of an organic peroxide in order to provide the resin with heat crosslinkability, a wide temperature range is allowed for melt molding of the resin.

The sheet may be flat in shape or may be fabricated in an embossed form or other forms. Moreover, in order to prevent sheets from blocking one another, the sheets may be stored with a releasing film on one of the sides. A sheet provided with emboss processing is preferable, because such a sheet provides glass and a solar cell with a cushioning effect and protects them from being damaged.

The sheet using the resin composition of the present invention is laminated on one side or both sides of a solar cell. If required, a surface protection layer may be laminated on the side opposing to the solar cell side of the laminated sheet and these are then used for solar cells.

There are no particular limitations to the method for fabricating a solar module. For example, a method comprising laminating a transparent front substrate of glass or the like, a sheet (which may be a sheet using the resin composition of the present invention), a solar cell and interconnecting connected to the solar cell, a sheet using the resin composition of the present invention, and a backsheet in this order, and gluing these with heat using vacuum suction may be generally used.

As the above-mentioned transparent front substrate, any substrate which can protect a layer consisting of a solar cell and a sheet made of the resin composition of the present invention without damaging performance as a solar cell may be used without any particular limitation. For example, a substrate made of glass, a polymethyl-methacrylate resin, a polycycloolefin resin, a fluorine-containing resin, a polyethylene terephthalate resin, a silicone resin, a polycarbonate resin, or the like can be used.
Since the sheet using the resin composition of the present invention has small moisture permeability and low hygroscopicity, the transparent front substrate does not necessarily have water barrier properties. It is possible to use a lightweight transparent resin sheet.

The backsheet is not indispensable as a water barrier layer. Such a sheet may be provided in order to mitigate a mechanical impact. An inexpensive sheet having excellent mechanical strength such as a polyethylene terephtharate resin sheet, a polycarbonate resin sheet, or the like can be used.
The backsheet may have light shielding and/or light reflexing properties in order to further improve durability of the solar module. In this case, the backsheet is suitable to use a material containing a light shielding pigment such as an UV absorber, titanium oxide, or the like.

A layer of a known adhesive or adhesive resin may be provided between the transparent front substrate and the sheet made of the resin composition of the present invention and/or between the sheet made of the resin composition of the present invention and the backsheet.

### [Example]

The present invention will be described in more detail by way of Examples and Comparative Examples, which are not intended to limit the present invention. In the following Examples and Comparative Examples, "part" and "%" are shown on the weight basis, unless otherwise indicated.

Various properties were measured according to the following methods.

### (1) Weight average molecular weight (Mw) and molecular weight distribution (Mw/Mn)

Molecular weight of block copolymers and hydrogenated block copolymers was measured by GPC as a standard polystyrene-reduced value using THF as an eluent at 38°C. HLC8020 GPC (manufactured by Tosoh Corp.) was used as a measuring device.

### (2) Hydrogenation rate

The hydrogenation rate of the main chain, side chain, and aromatic ring of a hydrogenated block copolymer was calculated by measuring ¹H-NMR spectrum of the hydrogenated block copolymer.

### (3) Light transmission

Light transmission of the resin composition for encapsulating a solar cell was measured using an extrusion-molded sheet according to ASTM D-1003, excepting for Comparative Example 2 in which a press-formed sheet was used.

### (4) Water absorption

A test specimen with a size of 3 mm in thickness and 50 mm in length and width was prepared from the resin composition for encapsulating a solar cell by press-forming and the moisture absorption was measured according to ASTM D570 at 23°C and dipping time of 24 hours.

### (5) Tensile modulus of elasticity, tensile strength, and tensile elongation

With the exception of Comparative Example 2, the extrusion-molded sheet of the resin composition for encapsulating a solar cell was used for measuring these properties according to the method of JIS K 7127/5/200 using Tensilon universal tester (RTC-1125A, product norbornene ORIENTIC). Tensile test was carried out using a type 5 test specimen, at 23°C and a chuck distance of 10 cm. The tensile modulus of elasticity was measured according to the method of JIS K7161. The strength at the time of fracture was regarded as the tensile strength and the elongation at the time of fracture was regarded as the tensile elongation. The press-formed sheet was used in Comparative Example 2.

### (6) Volume resistivity

Volume resistivity was measured at 23°C according to JIS K 6911 using a test specimen with a thickness of 1 mm which was prepared by piling three extrusion-molded sheets made of a resin composition for encapsulating a solar cell and press-forming the piled three sheets, provided that a press-formed sheet with a thickness of 1 mm was used in Comparative Examples 2.

### (7) Evaluation of adhesiveness with glass substrate

An extrusion-molded sheet of the resin composition for encapsulating a solar cell provided with a non-adhesive potion at the end of the sheet was superposed on a soda lime glass substrate having a thickness of 2 mm, and hot melt laminated at 180°C for five minutes using a vacuum laminator (MVLP, manufactured by Meiki Co., Ltd.) to obtain a test specimen for peeling test. A 90° peeling test was carried out by a method conforming to JIS K 6854-1 by producing a cut on the surface of the sheet at 15 mm intervals and pulling the non-adhesive portion at a rate of 50 mm/min to measure the peel strength, provided that a press-formed sheet was used in Comparative Example 2. The smaller the value of adhesiveness with glass, the smaller the peel strength.

### (8) Weather resistance

A lamination test specimen was prepared from glass and an extrusion-molded sheet of the resin composition for encapsulating a solar cell to evaluate the adhesiveness with a glass substrate. A white PET film (Lumirror^{®} E20, 125 micrometers in thickness, manufactured by Toray Industries, Inc.) was superposed on the back side of the test specimen (the side opposing to the glass substrate which was used as a light source side). The glass substrate side of the test specimen was exposed to light from a Sunshine carbon arc light for 1000 hours using a Sunshine weather meter (WEL-SUN-HC-B, manufactured by Suga Test Instruments Co., Ltd.) under the conditions of a black panel temperature of 63°C and 50%RH. Then, the light transmission of the test specimen prepared by a lamination of glass substrate and extrusion-molded sheet of the resin composition for encapsulating solar cell was measured.

### (9) Corrosion resistance of encapsulated copper plate

A test specimen for evaluating corrosion resistance was prepared from two extrusion-molded sheets of a resin composition for encapsulating a solar cell and a copper plate with a thickness of 0.3 mm, of which the surface was etched with an acetic acid aqueous solution and washed with water to remove oxides. The copper plate was sandwiched between the two sheets of the resin composition and encapsulated therein by heating at 180°C for five minutes using a vacuum laminator. The test specimen was left under an environment of 85°C and 85% RH for one month to inspect appearance, odor, and discoloration of copper foil.

### (10) Durability evaluation of solar module

An extrusion-molded sheet of the resin composition for encapsulating a solar cell was put on a transparent substrate (soda lime glass), and a polycrystalline silicon solar cell was put on the transparent substrate. After connecting copper foil interconnecting to the solar cell, the extrusion-molded sheet of the resin composition for encapsulating a solar cell, a backsheet (made from polyethylene terephthalate) were laid on the solar cell, thereby obtaining a laminate. Next, the laminate was encapsulated by heating for five minutes at 180°C under vacuum in a vacuum laminator to obtain a solar module.
This solar module was subjected to a 500 cycle test, one cycle consisting of cooling for 30 minutes at -40°C and heating for 30 minutes at 90°C. After the cycle test, the solar module was inspected by the naked eye to confirm the presence or absence of deformation. In addition, five solar cell were inspected by a C-mode ultrasonic scanning microscope (manufactured by SONIX) to confirm the presence or absence of cracks. Products in which neither deformation nor cracks were observed were evaluated as "Good".

### [Reference Example 1] Preparation of hydrogenated block copolymer [A] and pellets of hydrogenated block copolymer [A]

A reactor equipped with a stirrer, of which the internal space was replaced with nitrogen, was charged with 550 parts of dehydrated cyclohexane, 25.0 parts of dehydrated styrene, and 0.475 parts of n-dibutyl ether. While the mixture was stirred at 60°C, 0.515 parts of n-butyl lithium (15% cyclohexane solution) was added to initiate polymerization. The mixture was reacted for 60 minutes while stirring at 60°C. At this point of time, the polymerization conversion rate measured by gas chromatography (hereafter the same) was 99.5%.
Next, 50.0 parts of dehydrated isoprene was added and stirring was continued for 30 minutes at the same temperature. The polymerization conversion rate at this point of time was 99%.
Then, 25.0 parts of dehydrated styrene was further added and the mixture was stirred for 60 minutes at the same temperature. The polymerization conversion rate at this point of time was almost 100%. The reaction was terminated by adding 0.5 parts of isopropyl alcohol to the reaction solution to obtain a solution (polymer solution) containing a block copolymer (A).
The weight average molecular weight (Mw) of the resulting block copolymer (A) was 81,400, and the molecular weight distribution (Mw/Mn) was 1.05.

The above-mentioned polymer solution was fed to a pressure-resistant reactor equipped with a stirrer, and 0.4 parts of a nickel catalyst supported on silica alumina (E22U, an amount of nickel supported: 60%, manufactured by JGC Chemical Industry Company) as a hydrogenation catalyst and 100 parts of dehydrated cyclohexane were added and mixed. After replacing the internal atmosphere with hydrogen gas, the block copolymer was hydrogenated by supplying hydrogen at a temperature of 170°C and under a pressure of 4.5 MPa for 6 hours while stirring the solution. The weight average molecular weight (Mw) of the hydrogenated block copolymer (A) after the hydrogenation reaction was 86, 200, and the molecular weight distribution (Mw/Mn) was 1.06.

After the hydrogenation reaction, the reaction solution was filtered to remove the hydrogenation catalyst. The resulting hydrogenated block copolymer was dissolved in 1.0 part of a xylene solution containing 0.1 part of phosphorus antioxidant, 6-[3-(3-t-butyl-4-hydroxy-5-methylphenyl)propoxy]-2,4,8,10-tetrakis-t-butyldibenzo[d,f][1.3.2]dioxaphosphepin (Sumilizer^{®} GP, manufactured by Sumitomo Chemical Industries Co., Ltd. (hereinafter referred to as "Antioxidant A")) dissolved therein.

In order to remove minute solid components, the solution was sequentially filtered through Zeta-plus^{®} filter 30H (manufactured by CUNO, pore size: 0.5 to 1 micrometer) and another filter made from metal fiber (pore diameter: 0.4 micrometer, manufactured by Nichidai Co., Ltd.). Then, cyclohexane and xylene which were used as solvents and other volatile components were removed using a cylinder-type concentration oven (Kontro, manufactured by Hitachi, Ltd.) at a temperature of 260°C and under a pressure not more than 0.001 MPa. The residue in a molten state was extruded in a stranded form from a die directly connected to the concentration oven. The extruded product was cooled and pelletized to obtain 85 parts of pellets containing hydrogenated block copolymer [A] and antioxidant A (pellets of hydrogenated block copolymer [A]). The weight average molecular weight (Mw) of the resulting hydrogenated block copolymer [A] was 85, 300, and the molecular weight distribution (Mw/Mn) was 1.11. The hydrogenation rate was about 100%.

### [Reference Example 2] Preparation of hydrogenated block copolymer [B] and pellets of hydrogenated block copolymer [B]

A hydrogenated block copolymer [B] and 88 parts of pellets of the hydrogenated block copolymer [B] containing the antioxidant A were prepared in the same manner as in Reference Example 1, except that 15.0 parts of styrene, 0.310 parts of n-butyl lithium (15% cyclohexane solution), 70.0 parts of isoprene, and 15.0 parts of styrene were added in the polymerization step as monomers in this order. The weight average molecular weight (Mw) of the resulting hydrogenated block copolymer [B] was 139, 000, and the molecular weight distribution (Mw/Mn) was 1.15. The hydrogenation rate was about 100%.

### [Reference Example 3] Preparation of hydrogenated block copolymer [C] and pellets of hydrogenated block copolymer [C]

A hydrogenated block copolymer [C] and 87 parts of pellets of the hydrogenated block copolymer [C] containing the antioxidant A were prepared in the same manner as in Reference Example 1, except that 20.0 parts of a monomer mixture of styrene and isoprene (90:10), 60.0 parts of a monomer mixture of styrene and isoprene (10:90), 20.0 parts of the monomer mixture of styrene and isoprene (90:10) were added in this order in the polymerization step as monomers. The weight average molecular weight (Mw) of the resulting hydrogenated block copolymer [C] was 141, 000, and the molecular weight distribution (Mw/Mn) was 1.15. The hydrogenation rate was about 100%.

### [Reference Example 4] Preparation of hydrogenated block copolymer [D] and pellets of hydrogenated block copolymer [D]

A hydrogenated block copolymer [D] and 87 parts of pellets of the hydrogenated block copolymer [D] containing the antioxidant A were prepared in the same manner as in Reference Example 1, except that 25.0 parts of styrene, 50.0 parts of liquefied butadiene instead of isoprene, 25.0 parts of styrene were added as monomers in this order in the polymerization step. The weight average molecular weight (Mw) of the resulting hydrogenated block copolymer [D] was 84, 500, and the molecular weight distribution (Mw/Mn) was 1.11. The hydrogenation rate was about 100%.

### [Reference Example 5] Synthesis of hydrogenated polyisoprene

82 parts of pellets of hydrogenated polyisoprene were prepared in the same manner as in Reference Example 1, without using styrene, but using only 100 parts of isoprene in the polymerization step. The weight average molecular weight (Mw) of the resulting hydrogenated polyisoprene was 78, 500, and the molecular weight distribution (Mw/Mn) was 1.07. The hydrogenation rate was about 100%.

### [Reference Example 6] Preparation of hydrogenated block copolymer [E] and pellets of hydrogenated block copolymer [E]

A hydrogenated block copolymer [E] and 90 parts of pellets of the hydrogenated block copolymer [E] containing the antioxidant A were prepared in the same manner as in Reference Example 1, except that 35.0 parts of styrene, 30.0 parts of isoprene, and 35.0 parts of styrene were added in the polymerization step as monomers in this order. The weight average molecular weight (Mw) of the resulting hydrogenated block copolymer [E] was 86, 900, and the molecular weight distribution (Mw/Mn) was 1.10. The hydrogenation rate was about 100%.

### [Reference Example 7] Preparation of hydrogenated block copolymer [F] and pellets of hydrogenated block copolymer [F]

A hydrogenated block copolymer [F] and 90 parts of pellets of the hydrogenated block copolymer [F] containing the antioxidant A were prepared in the same manner as in Reference Example 1, except that 5.0 parts of styrene, 90.0 parts of isoprene, and 5.0 parts of styrene were added in the polymerization step as monomers in this order. The weight average molecular weight (Mw) of the resulting hydrogenated block copolymer [F] was 79, 700, and the molecular weight distribution (Mw/Mn) was 1.10. The hydrogenation rate was about 100%.

### [Example 1]

### (Preparation of resin composition for encapsulating a solar cell [A1])

2.0 parts of a reaction product of N,N'-bis(2,2,6,6-tetramethyl-4-piperidinyl)-1,6-hexanediamine (a hindered amine photostabilizer) and a polymer of N-butyl-1-butanamine and N-butyl-2,2,6,6-tetramethyl-4-piperidinamine (CHIMASSORB^{®} 2020, manufactured by Ciba Japan) was added to 100 parts of pellets of hydrogenated block copolymer [A] obtained in Reference Example 1. The mixture was kneaded at 250°C and extruded using a bi-axial extruder (TEM35B, manufactured by Toshiba Machine) in a stranded form. After cooling with water, the kneaded product was cut using a pelletizer to obtain 95 parts of pellets of a resin composition for encapsulating a solar cell [A1] which contains hydrogenated block copolymer [A].

### (Extrusion-molded sheet)

Extrusion-molded sheet [SA1] with a thickness of 400 micrometer and a width of 500 mm was obtained from pellets of the resin composition for encapsulating a solar cell [A1] by heating at 50°C for four hours using a hot air circulating dryer to remove dissolved air, and extruding from a T die film melt extruder (T die width: 500 mm) equipped with a 400 mmφ screw under the conditions of a molten resin temperature of 210°C, a T die temperature of 210°C, and a roll temperature of 50°C. The resulting extruded sheet [SA1] was laminated with a polyethylene release film and wound around a roll to collect the product sheet.

### (Preparation of test specimen)

Test sheet specimens [PA1] (thickness: 3 mm and 1 mm) were prepared from the pellets of a resin composition for encapsulating a solar cell [A1] using a press forming machine under the conditions of a resin temperature of 180°C and a pressure of 1.1 MPa.

### (Evaluation of resin composition for encapsulating a solar cell)

Light transmission, water absorption, tensile strength, tensile elongation, volume resistivity, adhesiveness with a glass substrate, encapsulated copper plate corrosion resistance, and weather resistance were evaluated using the extrusion-molded sheets [SA1] and press-formed test specimens [PA1]. Durability of the solar module was also evaluated. The results are shown in Table 1.

### [Example 2]

### (Resin composition for encapsulating a solar cell [A2])

2.0 parts of the same hindered amine photostabilizer as used in Example 1 and 0.2 parts of 2-(2H-benzotriazol-2-yl)-4-(1,1,3,3-tetramethylbutyl)phenol (a benzotriazole UV absorber, TINUVIN^{®} 329, manufactured by Ciba Japan) were added to 100 parts of pellets of the hydrogenated block copolymer [A] obtained in Reference Example 1. The mixture was kneaded in the same manner as in Example 1 to obtain 95 parts of pellets of a resin composition for encapsulating a solar cell [A2].
Extrusion-molded sheets [SA2] and press-formed test specimens [PA2] were prepared from the pellets of the resin composition for encapsulating a solar cell [A2] in the same manner as in Example 1. Light transmission, water absorption, tensile strength, tensile elongation, volume resistivity, adhesiveness with a glass substrate, encapsulated copper plate corrosion resistance, and weather resistance were evaluated using the extrusion-molded sheets [SA2] and press-formed test specimens [PA2]. Durability of the solar module was also evaluated. The results are shown in Table 1.

### Example 3

### (Resin composition for encapsulating a solar cell [B])

The same photostabilizer and UV absorber as used in Example 2 were added to 100 parts of pellets of the hydrogenated block copolymer [B] obtained in Reference Example 2. The mixture was kneaded in the same manner as in Example 1 to obtain 93 parts of pellets of the resin composition for encapsulating a solar cell [B].
Extrusion-molded sheets [SB] and press-formed test specimens [PB] were prepared from the pellets of the resin composition for encapsulating a solar cell [B] in the same manner as in Example 1. Light transmission, water absorption, tensile strength, tensile elongation, volume resistivity, adhesiveness with a glass substrate, encapsulated copper plate corrosion resistance, and weather resistance were evaluated using the extrusion-molded sheets [SB] and press-formed test specimens [PB]. Durability of the solar module was also evaluated. The results are shown in Table 1.

### Example 4

### (Resin composition for encapsulating a solar cell [C])

The same photostabilizer and UV absorber as used in Example 2 were added to 100 parts of pellets of the hydrogenated block copolymer [C] obtained in Reference Example 3. The mixture was kneaded in the same manner as in Example 1 to obtain 95 parts of pellets of the resin composition for encapsulating a solar cell [C].
Extrusion-molded sheets [SC] and press-formed test specimens [PC] were prepared from the pellets of the resin composition for encapsulating a solar cell [C] in the same manner as in Example 1. Light transmission, water absorption, tensile strength, tensile elongation, volume resistivity, adhesiveness with a glass substrate, encapsulated copper plate corrosion resistance, and weather resistance were evaluated using the extrusion-molded sheets [SC] and press-formed test specimens [PC]. Durability of the solar module was also evaluated. The results are shown in Table 1.

### Example 5

### (Resin composition for encapsulating a solar cell [D])

The same photostabilizer and UV absorber as used in Example 2 were added to 100 parts of pellets of the hydrogenated block copolymer [D] obtained in Reference Example 4. The mixture was kneaded in the same manner as in Example 1 to obtain 95 parts of pellets of the resin composition for encapsulating a solar cell [D].
Extrusion-molded sheets [SD] and press-formed test specimens [PD] were prepared from the pellets of the resin composition for encapsulating a solar cell [D] in the same manner as in Example 1. Light transmission, water absorption, tensile strength, tensile elongation, volume resistivity, adhesiveness with a glass substrate, encapsulated copper plate corrosion resistance, and weather resistance were evaluated using the extrusion-molded sheets [SD] and press-formed test specimens [PD]. Durability of the solar module was also evaluated. The results are shown in Table 1.

### Example 6

### (Resin composition for encapsulating a solar cell [A3])

10 parts of an alicyclic saturated hydrocarbon resin (ARKON^{®} KR1842, manufactured by Arakawa Chemical Industries, Ltd.) and the same photostabilizer and UV absorber as used in Example 2 were added to 100 parts of pellets of the hydrogenated block copolymer [A] obtained in Reference Example 1. The mixture was kneaded in the same manner as in Example 1 to obtain 106 parts of pellets of the resin composition for encapsulating a solar cell [A3].
Extrusion-molded sheets [SA3] and press-formed test specimens [PA3] were prepared from the pellets of the resin composition for encapsulating a solar cell [A3] in the same manner as in Example 1. Light transmission, water absorption, tensile strength, tensile elongation, volume resistivity, adhesiveness with a glass substrate, encapsulated copper plate corrosion resistance, and weather resistance were evaluated using the extrusion-molded sheets [SA3] and press-formed test specimens [PA3]. Durability of the solar module was also evaluated. The results are shown in Table 1.

### [Comparative Example 1]

### (Resin composition for encapsulating a solar cell [A3])

The same photostabilizer and UV absorber as used in Example 2 were added to 100 parts of an ethylene-vinyl acetate copolymer (EVAFLEX^{®} EV250, vinyl acetate content: 28 wt%, manufactured by Du Pont-Mitsui Polychemicals Co., Ltd). The mixture was kneaded in the same manner as in Example 1, except that the forming temperature was 220°C, to obtain 94 parts of pellets of the resin composition for encapsulating a solar cell [EV1].
Extrusion-molded sheets [SEV1] and press-formed test specimens [PEV1] were prepared from the pellets of the resin composition for encapsulating a solar cell [EV1] in the same manner as in Example 1, except that the press-forming temperature was 150°C and the extrusion-forming temperature was 190°C. Light transmission, water absorption, tensile strength, tensile elongation, volume resistivity, adhesiveness with a glass substrate, encapsulated copper plate corrosion resistance, and weather resistance were evaluated using the extrusion-molded sheets [SEV1] and press-formed test specimens [PEV1]. Durability of the solar module was also evaluated. The results are shown in Table 1.

### [Comparative Example 2]

The same photostabilizer and UV absorber as used in Example 2 were added to 100 parts of the same ethylene-vinyl acetate copolymer as used in Comparative Example 1. 0.1 part of 2,5-dimethyl-2,5-di(t-butylperoxy)hexane (PERHEXA^{®} 25B, manufactured by NOF Corp.), as an organic peroxide, and 0.5 parts of triallylisocyanurate (M-60, manufactured by Nippon Kasei Chemical Co., Ltd.), as a cross-linking assistant, were further added and the resulting mixture was kneaded using a Labo Plastomill (manufactured by Toyo Seiki Seisaku-Sho, Ltd.) for one minute at a resin temperature of 110°C to obtain 90 parts of a resin composition for encapsulating a solar cell [EV2].
Press-formed test specimens [PSEV2] with thicknesses of 3 mm and 1 mm, and press-formed sheets [PSEV2] with a thickness of 400 µm were prepared from the resin composition for encapsulating a solar cell [EV2] in the same manner as in Example 1, except that the press-forming temperature was 110°C. Light transmission, water absorption, tensile strength, tensile elongation, volume resistivity, adhesiveness with a glass substrate, encapsulated copper plate corrosion resistance, and weather resistance were evaluated using the press-formed test specimens [PEV2] and press-formed sheets [PSEV2]. Durability of the solar module was also evaluated. The results are shown in Table 1.

### [Comparative Example 3]

### (Resin composition for encapsulating a solar cell [E])

The same photostabilizer and UV absorber as used in Example 2 were added to 100 parts of pellets of the hydrogenated block copolymer [E] obtained in Reference Example 6. The mixture was kneaded in the same manner as in Example 1 to obtain 93 parts of pellets of the resin composition for encapsulating a solar cell [E].
Extrusion-molded sheets [SE] and press-formed test specimens [PE] were prepared from the pellets of the resin composition for encapsulating a solar cell [E] in the same manner as in Example 1. Light transmission, water absorption, tensile strength, tensile elongation, volume resistivity, adhesiveness with a glass substrate, encapsulated copper plate corrosion resistance, and weather resistance were evaluated using the extrusion-molded sheets [SE] and press-formed test specimens [PE]. Durability of the solar module was also evaluated. The results are shown in Table 1.

### [Comparative Example 4]

### (Resin composition for encapsulating a solar cell [F])

The same photostabilizer and UV absorber as used in Example 2 were added to 100 parts of pellets of the hydrogenated block copolymer [F] obtained in Reference Example 7. The mixture was kneaded in the same manner as in Example 1 to obtain 93 parts of pellets of the resin composition for encapsulating a solar cell [F]. Extrusion-molded sheets [SF] and press-formed test specimens [PF] were prepared from the pellets of the resin composition for encapsulating a solar cell [F] in the same manner as in Example 1. Light transmission, water absorption, tensile strength, tensile elongation, volume resistivity, adhesiveness with a glass substrate, encapsulated copper plate corrosion resistance, and weather resistance were evaluated using the extrusion-molded sheets [SF] and press-formed test specimens [PF]. Durability of the solar module was also evaluated. The results are shown in Table 1.

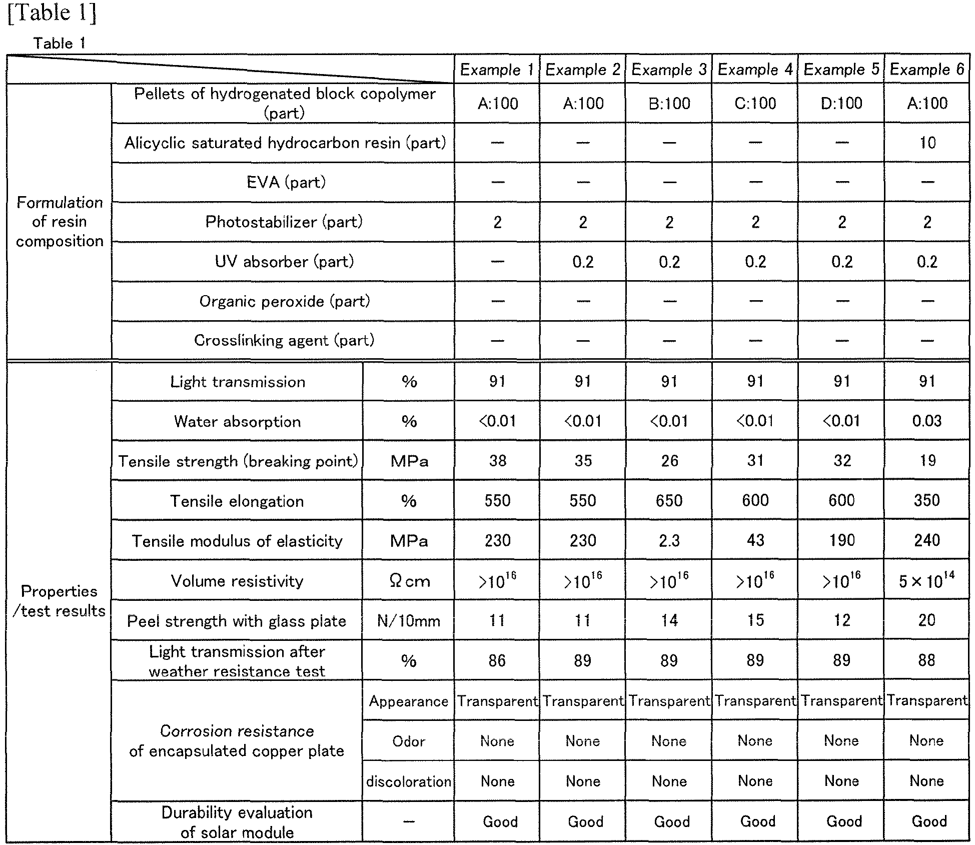

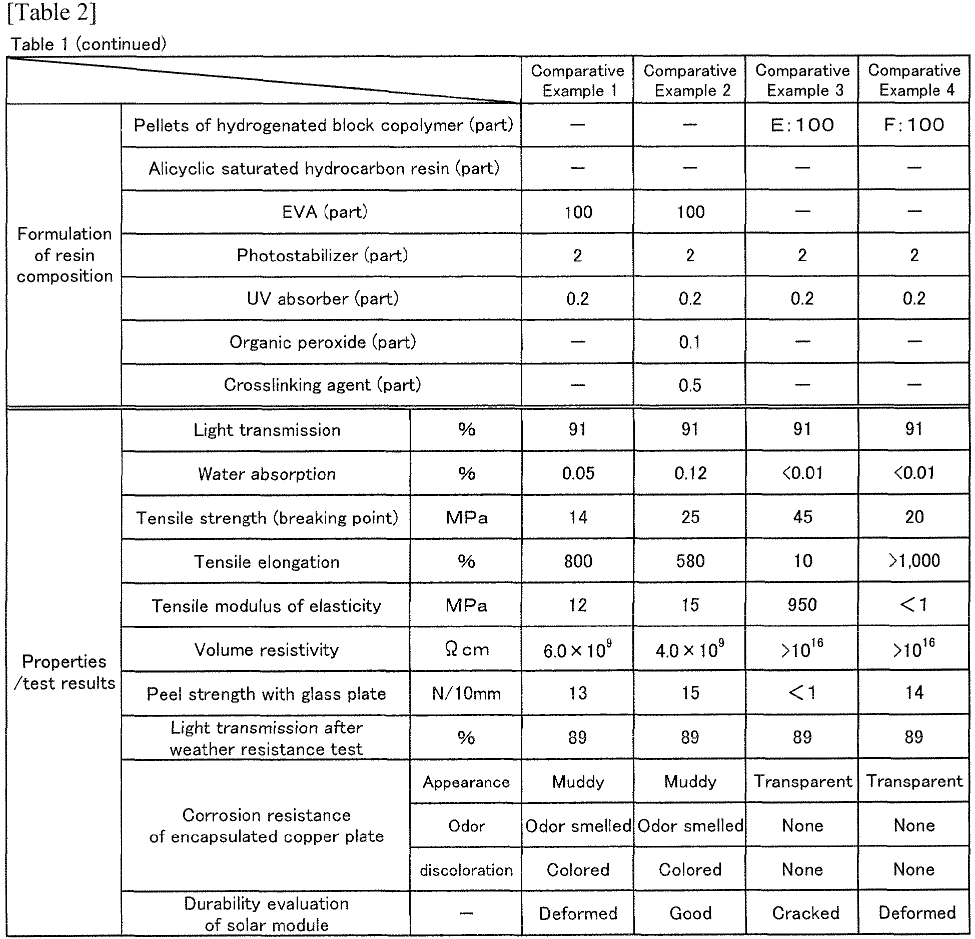

The following discussions apply to the results shown in Table 1.
The resin composition of the present invention is excellent in light transmission, water absorptivity, mechanical strength, flexibility, adhesive properties with glass, and weather resistance, and the solar module having a solar cell encapsulated with the resin composition is excellent in durability (Examples 1-6).
On the other hand, a module using ethylene-vinyl-acetate copolymer (EVA) as a encapsulating material may have corrosion in internal interconnecting if used for a long period of time in a high temperature and high humidity environment (Comparative Examples 1, 2).
If the resin contains a large amount of a polymer block having repeating units originating from an aromatic vinyl compound as a main component, the resin composition has poor tensile modulus of elasticity and poor adhesion with glass. A solar module has poor durability if this resin composition is used as a encapsulating material (Comparative Example 3).
If the amount of the polymer block having repeating units originating from an aromatic vinyl compound as a main component is small, the resin composition exhibits poor heat resistance, resulting in poor durability of a solar module (Comparative Example 4).

### [Industrial Applicability]

The resin composition of the present invention is useful for encapsulating a solar cell.

### [Explanation of Symbols]

- 1: Transparent front substrate
- 2: Solar cell
- 3: Encapsulating material
- 4: Interconnecting
- 5: Underside cover sheet

## Claims

1. A resin composition for encapsulating a solar cell comprising a hydrogenated block copolymer obtained by hydrogenating 90% or more of total unsaturated bonds, which is a total of carbon-carbon unsaturated bonds of main chains and side chains and carbon-carbon unsaturated bonds of aromatic rings, present in a block copolymer, which comprises at least two polymer blocks [A] having a repeating unit originating from an aromatic vinyl compound as a main component and at least one polymer block [B] comprising a repeating unit originating from a chain-like conjugated diene compound as a main component and in which the ratio of the weight fraction (wA) of the total polymer blocks [A] in the total block copolymer to the weight fraction (wB) of the total polymer block [B] in the total block copolymer (wA:wB) is 20:80 to 60:40, the resin composition having a tensile elasticity (at 23°C) of 1.0 to 500 MPa.

2. The resin composition for encapsulating a solar cell according to claim 1, wherein the weight average molecular weight of the hydrogenated block copolymer is 30,000 to 200,000.

3. The resin composition for encapsulating a solar cell according to claim 1 or 2, wherein the block copolymer is a triblock copolymer having the polymer block [A] bonded to the both ends of the polymer block [B].

4. The resin composition for encapsulating a solar cell according to any one of claims 1 to 3, comprising 0.01 to 1 part by weight of a phosphorus-containing antioxidant for 100 parts by weight of the hydrogenated block copolymer.

5. The resin composition for encapsulating a solar cell according to claim 4, further comprising 0.1 to 10 parts by weight of a hindered amine-containing antioxidant for 100 parts by weight of the hydrogenated block copolymer.

6. The resin composition for encapsulating a solar cell according to claim 5, further comprising 0.01 to 1 part by weight of a UV absorber for 100 parts by weight of the hydrogenated block copolymer.

7. A solar module encapsulated with the resin composition for encapsulating a solar cell according to any one of claims 1 to 6.
